# EUROPEAN PATENT APPLICATION

(11) **EP 4 661 265 A1**
(43) Date of publication of application: **10.12.2025**
(21) Application number: 25180538.8
(22) Date of filing: 03.06.2025
(51) Int. Cl.: H02M 1/00, H02M 1/42

(54) **SWITCHING LOSS REDUCTION AT NO LOAD CONDITIONS**

(30) Priority: 04.06.2024 US 202463655979 P
(71) Applicant: RGB Systems, Inc., Anaheim, CA 92805 (US)
(72) Inventor: MUROKI, Jason Todd, Anaheim, 92805 (US)
(74) Representative: Secerna LLP

(57) **Abstract**

A system and methods for reducing switching losses during light to no load conditions is presented. Embodiments of the system disclosed herein include a bias circuit that modifies operation of the PFC controller of a power supply to reduce the occurrence of burst operation over time. The reduction in the number of occurrences of the burst operation over a time period when the power supply is operating in a light or no load condition reduces the amount of idle power.

## Description

### TECHNICAL FIELD

This application generally relates to a power factor correction controller and more specifically to reducing switching losses during light or no load conditions.

### BACKGROUND

Certain power supplies may include a power factor correction controller. The power factor correction controller may attempt to maintain a ratio of power flowing to a load to the power within the circuit at unity power, or a power factor of one.

It is generally desirable to make electronic as energy efficient as possible. As a load applied to a power supply reduces, it is often the case that efficiency decreases. Thus, it is desirable to increase the efficiency of a power supply under light or no load conditions.

### SUMMARY

The systems, methods and devices of this disclosure each have several innovative aspects, no single one of which is solely responsible for all of the desirable attributes disclosed herein. Details of one or more implementations of the subject matter described in this specification are set forth in the accompanying drawings and the description below.

In some aspects, the techniques described herein relate to a power supply including: a power factor correction controller including a gate driver node, a voltage sense node, a current multiplier node, a transconductance amplifier, and a comparator, wherein the transconductance amplifier compares a voltage sense signal corresponding to an output voltage of the power supply to a first reference voltage, and wherein the comparator compares an input to the comparator corresponding to an output of the transconductance amplifier to a second reference voltage to generate a zero power control signal; and a power factor correction bias circuit in electrical communication with the current multiplier node, wherein the power factor correction bias circuit applies an offset voltage to the current multiplier node to cause a modified current to be applied across an output inductor of the power supply when the zero power control signal activates a gate driver of the power supply during a no load condition.

In some aspects, the techniques described herein relate to a power supply, wherein the power factor correction bias circuit increases a time between a first activation of a gate driver and a second activation of the gate driver compared to a power supply without the power factor correction bias circuit.

In some aspects, the techniques described herein relate to a power supply, wherein the first activation of the gate driver includes a first set of ON/OFF switching of an output transistor for a first activation time period, and wherein the second activation of the gate driver includes a second set of ON/OFF switching of the output transistor for a second activation time period.

In some aspects, the techniques described herein relate to a power supply, wherein the modified current includes an increased current compared to a power supplied without the power factor correction bias circuit.

In some aspects, the techniques described herein relate to a power supply, wherein the power factor correction bias circuit includes a voltage supply in electrical communication with a voltage divider that is configured to generate the offset voltage.

In some aspects, the techniques described herein relate to a power supply, wherein the first reference voltage and the second reference voltage differ by less than a threshold difference.

In some aspects, the techniques described herein relate to a power supply, wherein the threshold difference is on the order of millivolts.

In some aspects, the techniques described herein relate to a power supply, wherein the transconductance amplifier is configured to generate a pull down current signal in response to determining, based on the voltage sense signal, that the output voltage exceeds an output voltage threshold thereby causing the zero power control signal to deactivate the gate driver.

In some aspects, the techniques described herein relate to a power supply, wherein the transconductance amplifier is configured to generate a pull up current signal in response to determining, based on the voltage sense signal, that the output voltage does not satisfy an output voltage threshold thereby causing the zero power control signal to activate the gate driver.

In some aspects, the techniques described herein relate to a power supply, wherein the power factor correction controller further comprises a multiplier configured to multiply a voltage amplifier output with a scaled full wave rectified AC input voltage to obtain a multiplier output at the current multiplier node.

In some aspects, the techniques described herein relate to an audio amplifier system including: an audio amplifier; and a power supply configured to power the audio amplifier, the power supply including: a power factor correction controller including a gate driver node, a voltage sense node, a current multiplier node, a transconductance amplifier, and a comparator, wherein the transconductance amplifier compares a voltage sense signal corresponding to an output voltage of the power supply to a first reference voltage, and wherein the comparator compares an input to the comparator corresponding to an output of the transconductance amplifier to a second reference voltage to generate a zero power control signal; and a power factor correction bias circuit in electrical communication with the current multiplier node, wherein the power factor correction bias circuit applies an offset voltage to the current multiplier node to cause a modified current to be applied across an output inductor of the power supply when the zero power control signal activates a gate driver of the power supply during a no load condition.

In some aspects, the techniques described herein relate to an audio amplifier system, wherein the power factor correction bias circuit increases a time between a first activation of a gate driver and a second activation of the gate driver compared to a power supply without the power factor correction bias circuit.

In some aspects, the techniques described herein relate to an audio amplifier system, wherein the first activation of the gate driver includes a first set of ON/OFF switching of an output transistor for a first activation time period, and wherein the second activation of the gate driver includes a second set of ON/OFF switching of the output transistor for a second activation time period.

In some aspects, the techniques described herein relate to an audio amplifier system, wherein the modified current includes an increased current compared to a power supplied without the power factor correction bias circuit.

In some aspects, the techniques described herein relate to an audio amplifier system, wherein the power factor correction bias circuit includes a voltage supply in electrical communication with a voltage divider that is configured to generate the offset voltage.

In some aspects, the techniques described herein relate to an audio amplifier system, wherein the first reference voltage and the second reference voltage differ by less than a threshold difference.

In some aspects, the techniques described herein relate to an audio amplifier system, wherein the threshold difference is on the order of millivolts.

In some aspects, the techniques described herein relate to an audio amplifier system, wherein the transconductance amplifier is configured to generate a pull down current signal in response to determining, based on the voltage sense signal, that the output voltage exceeds an output voltage threshold thereby causing the zero power control signal to deactivate the gate driver.

In some aspects, the techniques described herein relate to an audio amplifier system, wherein the transconductance amplifier is configured to generate a pull up current signal in response to determining, based on the voltage sense signal, that the output voltage does not satisfy an output voltage threshold thereby causing the zero power control signal to activate the gate driver.

In some aspects, the techniques described herein relate to an audio amplifier system, wherein the power factor correction controller further comprises a multiplier configured to multiply a voltage amplifier output with a scaled full wave rectified AC input voltage to obtain a multiplier output at the current multiplier node.

Although certain embodiments and examples are disclosed herein, inventive subject matter extends beyond the examples in the specifically disclosed embodiments to other alternative embodiments and/or uses, and to modifications and equivalents thereof.

### BRIEF DESCRIPTION OF THE DRAWINGS

Aspects and advantages of the embodiments provided herein are described with reference to the following detailed description in conjunction with the accompanying drawings. Throughout the drawings, reference numbers may be re-used to indicate correspondence between referenced elements. The drawings are provided to illustrate example embodiments described herein and are not intended to limit the scope of the disclosure. In addition, various features of different disclosed embodiments can be combined to form additional embodiments, which are part of this disclosure. Further, one or more features or structures can be removed or omitted.
Figure 1 illustrates an example of a power supply with a power factor correction (PFC) controller.
Figure 2 illustrates an example of a power supply with a power factor correction (PFC) controller and a PFC bias circuit in accordance with certain embodiments.
Figure 3A illustrates signal graphs illustrating operation of the power supply of Figure 1.
Figure 3B illustrates signal graphs illustrating operation of the power supply of Figure 2 in accordance with certain embodiments.
Figure 4 illustrates a circuit diagram of a portion of the power supply of Figure 2 in accordance with certain embodiments.

### DETAILED DESCRIPTION OF CERTAIN EMBODIMENTS

The headings provided herein, if any, are for convenience only and do not necessarily affect the scope or meaning of the claimed invention.

### Introduction

Many electronic products are powered by batteries. As such, it is often desirable to make electronic products as energy efficient as possible to extend battery life. Even in cases when an electronic product is powered by a mains electricity connection (e.g., plugged into an electrical outlet), it is desirable to make products energy efficient to, for example, reduce electricity usage.

Some electronic products (e.g., audio amplifiers) may include a power factor correction (PFC) controller. This PFC controller may be a part of a power supply of an electronic product. The PFC controller attempts to achieve a power factor of 1, also known as "unity power factor." The power factor is a ratio of power flowing to a load to an amount of power in a circuit. A power factor of 1 indicates that all power is effectively being converted into useful work or is being applied to the load.

As the output load of a power supply that includes a PFC controller reduces, efficiency tends to decrease. Even in cases where there is no load applied to the power supply, PFC switching losses may be significant. In some cases, the switching losses may be large enough to prevent a product from complying with energy efficiency standards. For example, suppose the input power under a no load condition is 0.5 watts. In some non-limiting cases, up to 70% of the 0.5 watts may be attributable to switching losses.

Some power supplies use a burst operation at no or light loads to reduce power losses attributed to switching losses while attempting to maintain a power factor of 1. Light loads may vary based on the normal operating load of the power supply. For example, a power supply configured to operate at 50 watts may operate at 2 watts under light load conditions whereas a power supply configured to operate at 500 watts may operate at 5-10 watts during light load conditions.

Embodiments of the present disclosure present a system and methods for further reducing switching losses during light to no load conditions. Embodiments of the present system may be implemented as part of an audio amplifier system. Embodiments of the system disclosed herein include a bias circuit that modifies operation of the PFC controller of a power supply to reduce the occurrence of burst operation over time. The reduction in the number of occurrences of the burst operation over a time period when the power supply is operating in a light or no load condition reduces the amount of idle power. In some cases, the reduction in idle power may be over 50% and in yet other cases, the reduction in idle power was over 70%. For example, in some cases, the system disclosed herein was found to reduce idle power for a power supply from 2.3 watts to as low as 0.8 watts. In other cases, the system disclosed herein reduced idle power from 1.3 watts to approximately 0.8 watts.

In some cases, the system disclosed herein may introduce some noise (e.g., a ripple voltage) in the power output. However, the amount of introduced noise is relatively low and is typically removed or smoothed by the existing filters or smoothing circuits included in many electronic products. Accordingly, the introduced rippled current may have little to no impact on most electronic products while the improved PFC controller presented herein may significantly reduce (e.g., by over 50% in some cases) power expenditure (or increase power efficiency) under light to no load conditions.

In certain embodiments, the bias circuit of the PFC controller presented herein may add a small DC offset (e.g., on the order of 10-20 millivolts) to the PFC controller current multiplier node. The DC offset applied to the PFC controller by the bias circuit can reduce the amount of bursting events while increasing the dead time between bursts resulting in significant power savings as described above. The burst events may each comprise a series or set of ON/OFF switching events where switches controlled by the PFC controller continue to switching between ON and OFF for an activation time period or a burst event time period. The dead time may refer to a period of time between burst events where the switches remain in a particular state (e.g., OFF).

### Example Power Supply

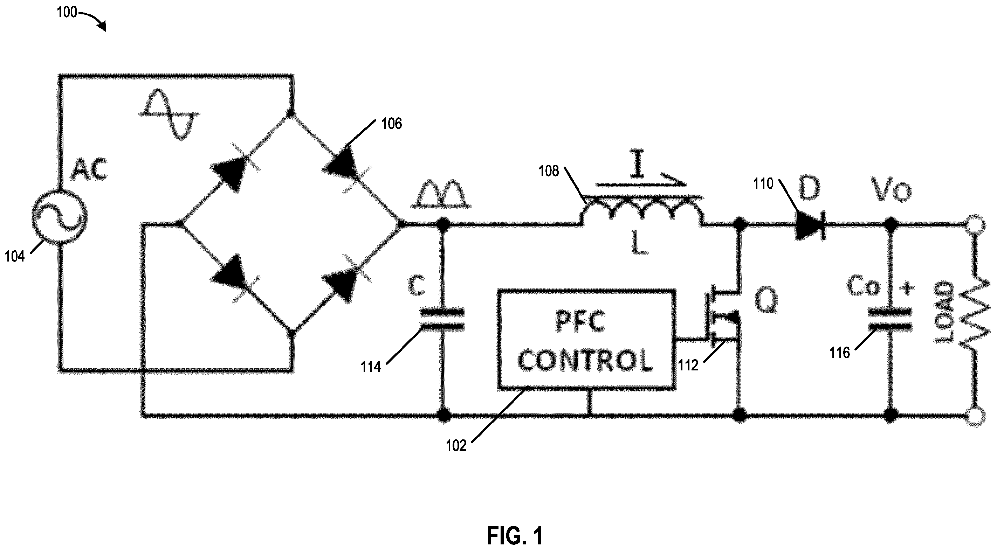

Figure 1 illustrates an example of a power supply 100 with a power factor correction (PFC) controller, the PFC controller 102. The power supply 100 may include a power source 104, such as a battery or connection to a mains power. The AC power signal may be rectified by a diode bridge 106 creating a rectified voltage signal across the capacitor 114. The corresponding current from the rectified voltage may be supplied to the inductor 108, which may then pass the current through the diode 110 to the output node Vo, where a voltage may be supplied to a load.

The PFC controller 102 detects the output voltage at the node Vo and attempts to maintain a power factor of 1. The PFC controller 102 may turn the switch 112 ON and OFF in an attempt to maintain a power factor of 1.

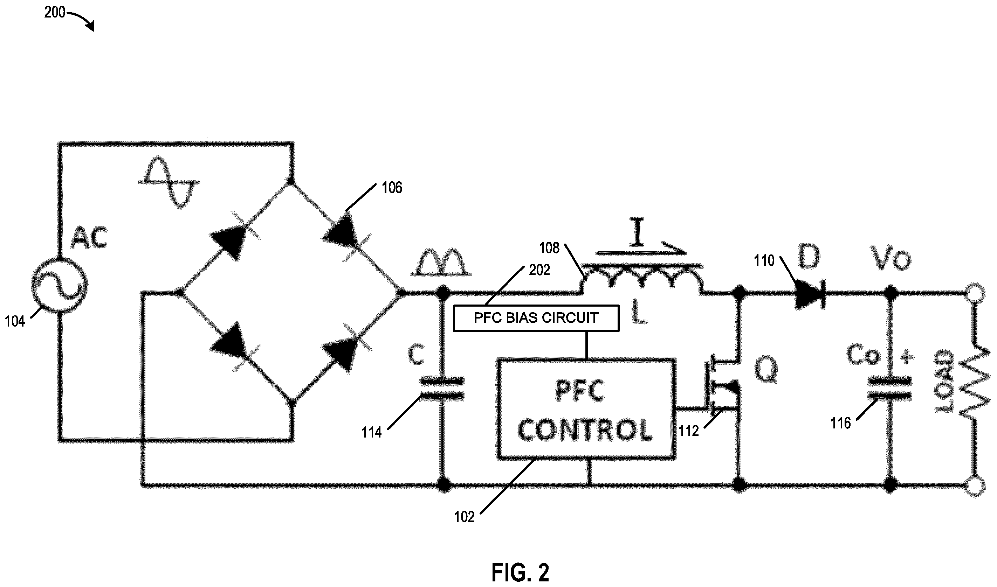

Figure 2 illustrates an example of a power supply 200 with a power factor correction controller, or PFC controller, and a power factor correction bias circuit 202, or PFC bias circuit 202, in accordance with certain embodiments. The power supply 200 includes one or more of the embodiments described with respect to the power supply 100. In addition, the power supply 200 includes a PFC bias circuit 202 that is configured to apply a DC offset of the PFC controller 102. The DC offset may be on the order of 10-20 mV. However, in some cases, the DC offset may be greater or smaller. The size of the DC offset may depend on the size of the power supply 200 or the wattage supported by the power supply 200.

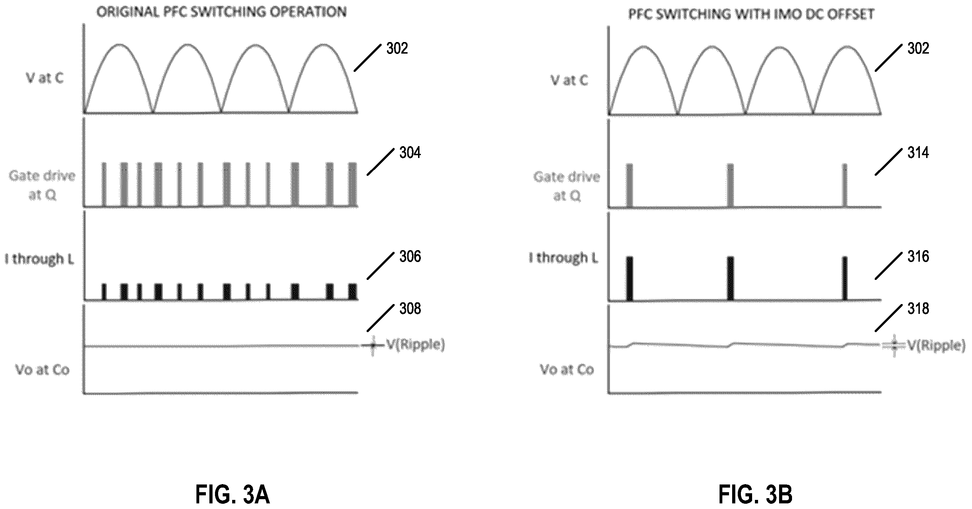

Figures 3A and 3B illustrate graphs that compare the operation of the power supply 100 and the power supply 200 during a no load condition, such as when an audio amplifier is in standby or is not receiving an input audio signal. Figure 3A illustrates signal graphs illustrating operation of the power supply 100 of Figure 1. Figure 3B illustrates signal graphs illustrating operation of the power supply 200 of Figure 2 in accordance with certain embodiments. The graph 302 illustrates the rectified AC voltage signal (e.g., the input voltage from the power source) across the capacitor 114.

The graph 304 illustrates a set of gate drive bursts over a time period T. Each bar in the graph 304 represents a series of ON and OFF signals output by the PFC controller 102 that cause an output transistor or the switch 112 to turn ON or OFF. In other words, the switch 112 may turn ON and OFF multiple times during each occurrence of a bar within the graph 304. The time between the gate drive bursts reflect time periods within the time period T when the switch 112 remains in an OFF state.

As illustrated by the graph 306, each time there is a gate drive burst, a current flows through the inductor 108. The current helps to maintain a constant output voltage across the capacitor 116 corresponding to the output voltage across the load of the power supply 100 as illustrated by the graph 308.

The graph 304, the graph 306 and the graph 308 correspond to operation of the power supply 100 over the time period T. The graph 314, the graph 316, and the graph 318 are corresponding graphs that correspond to the graph 304, the graph 306, and the graph 308, respectively, and that reflect the operation of the power supply 200 over the same time period T. As can be determined by comparing the graph 314 with the graph 304, the gate drive bursts happen much less frequently with the power supply 200 than with the power supply 100.

As with the graph 306, the graph 316 illustrates the current flow through the inductor 108 that occurs during each gate drive burst. However, as the gate drive bursts happen less frequently with the power supply 200, the occurrences of current flow through the inductor 108 happens less frequently. Further, the amount of dead time, or time during which the switch 112 remains OFF, is increased. But, comparing the graph 316 with the graph 306, it can be seen that the magnitude of the current flow in the power supply 200 is significantly higher, for example, more than double, than the magnitude of the current flow in the power supply 100 during each gate burst event.

Further, comparing the graph 318 with the graph 308, it can be seen that while the output voltage across the capacitor 116 is roughly the same with the power supply 200 as the power supply 100, there is a small ripple introduced into the output voltage by the increased current amplitude across the inductor 108. This small ripple or noise that is introduced into the output voltage has little or no impact on most devices because, for example, the ripple is filtered out or within tolerance of most electronic devices. Further, although the amount of current supplied during each burst event is higher, the reduction in burst events over a time period T results in power savings over the time period T compared to the power supply 100 when the power supply 200 is operating in a no load (or light load) condition. For example, in some cases, the power savings can be up to several watts.

### Example PFC Controller

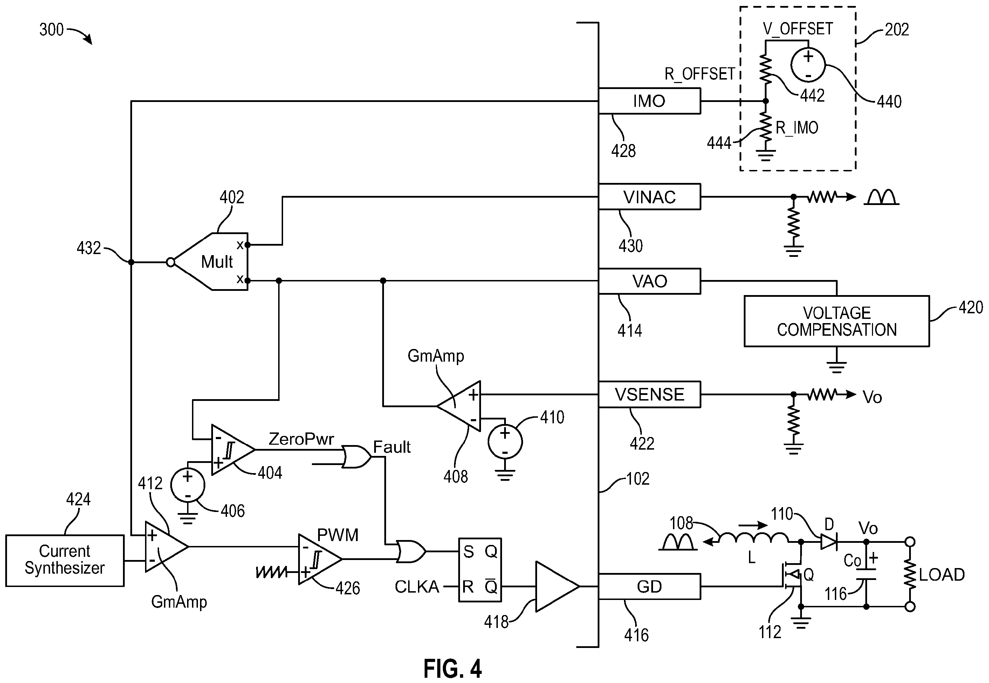

Figure 4 illustrates a circuit diagram 300 of a portion of the power supply 200 of Figure 2 in accordance with certain embodiments. The circuit diagram 300 includes a portion of the PFC controller 102 and the PFC bias circuit 202, which may be in electrical communication with the PFC controller 102 via the current multiplier node 432. The PFC controller 102 includes a multiplier 402, a comparator 404, a voltage source 406, a transconductance amplifier 408, a voltage source 410, and a transconductance amplifier 412.

The PFC controller 102 is configured to maintain the output voltage at a target level (e.g., 400 volts) and attempts to maintain a power factor of 1. The comparator 404 can compare a voltage received at the Voltage Amplifier Output or VAO pin 414 with a reference voltage generated by the voltage source 406 to generate a zero power control signal. The VAO pin 414 may receive an input voltage generated by the voltage compensation circuit 420 that corresponds to an error signal associated with an error between the actual output voltage and the desired reference voltage. Based on the outcome of comparison, the comparator 404 can output a signal (e.g., the zero power control signal) that indicates whether the zero power condition is satisfied. If the output of comparator 404 indicates a zero power condition is satisfied (e.g., a power factor of 1), the zero power control signal causes a gate driver node or the gate driver pin 416 to output a signal from the gate driver 418 that causes the switch 112 to enter or remain in an OFF state. In some cases, the comparator 404 detects whether the output voltage goes above or exceeds a target voltage at zero power. In some such cases, in response to determining that the output voltage exceeds the target voltage or output voltage threshold at zero power, the comparator 404 outputs a signal that causes the switch 112 to enter or remain in an OFF state. In some such cases, the zero power control signal may deactivate the gate driver 418.

If the output of comparator 404 indicates that a zero power condition is not satisfied (e.g., the output voltage does not satisfy an output voltage threshold), the zero power control signal causes the gate driver pin 416 to output a signal from the gate driver 418 associated with a burst mode that causes the switch 112 to alternate between an ON and OFF state. Thus, the zero power control signal may activate the gate driver of the power supply during a no load condition. The zero power condition may be determined to not be met when the output voltage begins to drop below a target or threshold voltage associated with the zero power condition. The burst mode of the switch 112 causes a current to flow through the inductor 108 and brings the output voltage back up towards the target output voltage at the node Vo.

The signal received at the VAO pin 414 may be modified based on an output of the transconductance amplifier 408. The output of the transconductance amplifier 408 may generate a pull up current signal or a pull down current signal to pull up or pull down the voltage input at the VAO pin 414 based on a comparison of a voltage sense signal with a reference voltage generated by the voltage source 410. The voltage sense signal may be received at the Vsense input pin 422 or a voltage sense node and may correspond to the voltage output. As illustrated, a voltage divider may be connected between the Vo and the Vsense input pin 422 providing a signal that is proportional to the voltage output. In some embodiments, the reference voltage generated by the voltage source 410 and the reference voltage generated by the voltage source 406 may differ by a threshold. In some cases, the threshold difference may be on the order of millivolts. For example, the difference may be less than 10 millivolts, between 10 and 20 millivolts, or more than 20 millivolts.

The multiplier 402 provides a voltage signal to the transconductance amplifier 412. The multiplier 402 output may be generated based on the voltage input at the VAO pin 414 and a voltage input corresponding to the rectified AC signal received at the Voltage INput AC pin referred to as the VINAC pin 430. In some embodiments, the VINAC is a scaled down (e.g., via a resistor divider circuit) version of the full wave rectified AC input voltage. The output of the multiplier 402 may be supplied to a current multiplier node 432, which may be connected to the transconductance amplifier 412 and the multiplier current output pin referred to as the IMO pin 428. The transconductance amplifier 412 may use the signal supplied by the multiplier 402 and the current synthesizer output generated by the current synthesizer 424 to generate a current which is supplied to the pulse width modulator 426. The output of the pulse width modulator 426 may control the bursting of the gate driver 418 when the output of the comparator 404 indicates a zero power condition is not satisfied.

The output of the multiplier 402 may be modified or offset by the PFC bias circuit 202. The offset supplied by the PFC bias circuit 202 may affect the output of the transconductance amplifier 412. Further, as illustrated in Figure 3B, not only may the bursting occur less frequently over a time period, but the current through the inductor 108 may be increased.

The DC offset supplied by the PFC bias circuit 202 may be on the order of a few millivolts. In some cases, the DC offset may be between 10-20 millivolts. In other cases, the DC offset may be greater than 20 millivolts. The DC offset may be supplied to the multiplier current output pin, or the IMO pin 428, by the PFC bias circuit 202 and modifies the output of the multiplier 402.

The PFC bias circuit 202 may include a voltage supply or a voltage source 440 that serves as a DC offset. The voltage output by the voltage source 440 may be supplied to a voltage divider formed from the resistor 442 and the resistor 444. By applying the DC offset at the IMO pin 428, the amount of switching over a time period T by the switch 112 is reduced, which results in power savings under a no load or a light load condition.

The DC offset voltage at the IMO pin 428 requests a higher current when the gate driver 418 for the switch 112 is engaged. Thus, the DC offset voltage may cause a modified current to be applied across the output inductor (e.g., the PFC inductor 108). During standby or other no or low load conditions, the bursts of the PFC controller 102 yield higher PFC inductor 108 current peaks. At each burst, the higher peaks may cause the output voltage Vo to overshoot the magnitude of the target voltage. This overshoot may be up to several Volts. Further, the overshoot may result in a voltage compensation signal being supplied at the VAO pin 414 that triggers a zero power or fault signal at the comparator 404 that halts the gate driver 418 for the switch 112. However, the overshoot condition may require additional time for Vo to discharge low enough to disengage the zero power condition.

As a result, the PFC controller 102 may burst less often with longer dead time between bursts. The PFC inductor 108 current peaks may be higher and, in some cases, the output voltage Vo may have some additional V(ripple). But less switching loss and lower input power are achieved.

### Terminology

Conditional language used herein, such as, among others, "can," "could," "might," "may," "e.g.," and the like, unless specifically stated otherwise, or otherwise understood within the context as used, may be generally intended to convey that certain embodiments include, while other embodiments do not include, certain features, elements and/or states. Thus, such conditional language may be not generally intended to imply that features, elements and/or states may be in any way required for one or more embodiments or that one or more embodiments necessarily include these features, elements and/or states.

Conjunctive language such as the phrase "at least one of X, Y, and Z," unless specifically stated otherwise, may be otherwise understood with the context as used in general to convey that an item, term, etc. may be either X, Y, or Z. Thus, such conjunctive language may be not generally intended to imply that certain embodiments require the presence of at least one of X, at least one of Y, and at least one of Z.

While the above detailed description may have shown, described, and pointed out novel features as applied to various embodiments, it may be understood that various omissions, substitutions, and/or changes in the form and details of any particular embodiment may be made without departing from the spirit of the disclosure. As may be recognized, certain embodiments may be embodied within a form that does not provide all of the features and benefits set forth herein, as some features may be used or practiced separately from others.

All of the processes described herein may be embodied in, and fully automated via, software code modules executed by a computing system that includes one or more computers or processors. The code modules may be stored in any type of non-transitory computer-readable medium or other computer storage device. Some or all the methods may be embodied in specialized computer hardware.

Many other variations than those described herein will be apparent from this disclosure. For example, depending on the embodiment, certain acts, events, or functions of any of the algorithms described herein can be performed in a different sequence, can be added, merged, or left out altogether (for example, not all described acts or events are necessary for the practice of the algorithms). Moreover, in certain embodiments, acts or events can be performed concurrently, for example, through multi-threaded processing, interrupt processing, or multiple processors or processor cores or on other parallel architectures, rather than sequentially. In addition, different tasks or processes can be performed by different machines and/or computing systems that can function together.

The various illustrative logical blocks and modules described in connection with the embodiments disclosed herein can be implemented or performed by a machine, such as a processing unit or processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A processor can be a microprocessor, but in the alternative, the processor can be a controller, microcontroller, or state machine, combinations of the same, or the like. A processor can include electrical circuitry configured to process computer-executable instructions. In another embodiment, a processor includes an FPGA or other programmable device that performs logic operations without processing computer-executable instructions. A processor can also be implemented as a combination of computing devices, for example, a combination of a DSP and a microprocessor, a plurality of microprocessors, one or more microprocessors in conjunction with a DSP core, or any other such configuration. Although described herein primarily with respect to digital technology, a processor may also include primarily analog components. A computing environment can include any type of computer system, including, but not limited to, a computer system based on a microprocessor, a mainframe computer, a digital signal processor, a portable computing device, a device controller, or a computational engine within an appliance, to name a few.

Additionally, features described in connection with one embodiment can be incorporated into another of the disclosed embodiments, even if not expressly discussed herein, and embodiments may have the combination of features still fall within the scope of the disclosure. For example, features described above in connection with one embodiment can be used with a different embodiment described herein and the combination still fall within the scope of the disclosure.

It should be understood that various features and aspects of the disclosed embodiments can be combined with, or substituted for, one another in order to form varying modes of the embodiments of the disclosure. Thus, it may be intended that the scope of the disclosure herein should not be limited by the particular embodiments described above. Accordingly, unless otherwise stated, or unless clearly incompatible, each embodiment of this disclosure may comprise, additional to its essential features described herein, one or more features as described herein from each other embodiment disclosed herein.

Features, materials, characteristics, or groups described in conjunction with a particular aspect, embodiment, or example may be to be understood to be applicable to any other aspect, embodiment or example described in this section or elsewhere in this specification unless incompatible therewith. All of the features disclosed in this specification (including any accompanying claims, abstract and drawings), and/or all of the steps of any method or process so disclosed, may be combined in any combination, except combinations where at least some of such features and/or steps may be mutually exclusive. The protection may be not restricted to the details of any foregoing embodiments. The protection extends to any novel one, or any novel combination, of the features disclosed in this specification (including any accompanying claims, abstract and drawings), or to any novel one, or any novel combination, of the steps of any method or process so disclosed.

Furthermore, the features and attributes of the specific embodiments disclosed above may be combined in different ways to form additional embodiments, all of which fall within the scope of the present disclosure. Also, the separation of various system components in the implementations described above should not be understood as requiring such separation in all implementations, and it should be understood that the described components and systems can generally be integrated together in a single product or packaged into multiple products.

Moreover, while operations may be depicted in the drawings or described in the specification in a particular order, such operations need not be performed in the particular order shown or in sequential order, or that all operations be performed, to achieve desirable results. Other operations that may be not depicted or described can be incorporated in the example methods and processes. For example, one or more additional operations can be performed before, after, simultaneously, or between any of the described operations. Further, the operations may be rearranged or reordered in other implementations, including being performed at least partially in parallel. Those skilled in the art will appreciate that in some embodiments, the actual steps taken in the processes illustrated and/or disclosed may differ from those shown in the figures. Depending on the embodiment, certain of the steps described above may be removed, others may be added.

For purposes of this disclosure, certain aspects, advantages, and novel features may be described herein. Not necessarily all such advantages may be achieved in accordance with any particular embodiment. Thus, for example, those skilled in the art will recognize that the disclosure may be embodied or carried out in a manner that achieves one advantage or a group of advantages as taught herein without necessarily achieving other advantages as may be taught or suggested herein.

Language of degree used herein, such as the terms "approximately," "about," "generally," and "substantially" as used herein represent a value, amount, or characteristic close to the stated value, amount, or characteristic that still performs a desired function or achieves a desired result. For example, the terms "approximately", "about", "generally," and "substantially" may refer to an amount that may be within less than 10% of, within less than 5% of, within less than 1% of, within less than 0.1% of, and within less than 0.01% of the stated amount. As another example, in certain embodiments, the terms "generally parallel" and "substantially parallel" refer to a value, amount, or characteristic that departs from exactly parallel by less than or equal to 15 degrees, 10 degrees, 5 degrees, 3 degrees, 1 degree, 0.1 degree, or otherwise.

The scope of the present disclosure may be not intended to be limited by the specific disclosures of preferred embodiments in this section or elsewhere in this specification, and may be defined by claims as presented in this section or elsewhere in this specification or as presented in the future. The language of the claims may be to be interpreted broadly based on the language employed in the claims and not limited to the examples described in the present specification or during the prosecution of the application, which examples may be to be construed as non-exclusive.

Unless the context clearly may require otherwise, throughout the description and the claims, the words "comprise", "comprising", and the like, may be construed in an inclusive sense as opposed to an exclusive or exhaustive sense, that may be to say, in the sense of "including, but not limited to".

Throughout the description and claims of this specification, the words "comprise" and "contain" and variations of them mean "including but not limited to" and they are not intended to (and do not) exclude other moieties, additives, components, integers or steps. Throughout the description and claims of this specification, the singular encompasses the plural unless the context otherwise requires. In particular, where the indefinite article is used, the specification is to be understood as contemplating plurality as well as singularity, unless the context requires otherwise.

Features, integers, characteristics or groups described in conjunction with a particular aspect, embodiment or example of the invention are to be understood to be applicable to any other aspect, embodiment or example described herein unless incompatible therewith. All of the features disclosed in this specification (including any accompanying claims, abstract and drawings), and/or all of the steps of any method or process so disclosed, may be combined in any combination, except combinations where at least some of the features and/or steps are mutually exclusive. The invention is not restricted to any details of any foregoing embodiments. The invention extends to any novel one, or novel combination, of the features disclosed in this specification (including any accompanying claims, abstract and drawings), or to any novel one, or any novel combination, of the steps of any method or process so disclosed.

The reader's attention is directed to all papers and documents which are filed concurrently with or previous to this specification in connection with this application and which are open to public inspection with this specification, and the contents of all such papers and documents are incorporated herein by reference.

## Claims

1. A power supply comprising:
a power factor correction controller comprising a gate driver node, a voltage sense node, a current multiplier node, a transconductance amplifier, and a comparator, wherein the transconductance amplifier compares a voltage sense signal corresponding to an output voltage of the power supply to a first reference voltage, and wherein the comparator compares an input to the comparator corresponding to an output of the transconductance amplifier to a second reference voltage to generate a zero power control signal; and
a power factor correction bias circuit in electrical communication with the current multiplier node, wherein the power factor correction bias circuit applies an offset voltage to the current multiplier node to cause a modified current to be applied across an output inductor of the power supply when the zero power control signal activates a gate driver of the power supply during a no load condition.

2. The power supply of claim 1, wherein the power factor correction bias circuit increases a time between a first activation of a gate driver and a second activation of the gate driver compared to a power supply without the power factor correction bias circuit.

3. The power supply of claim 2, wherein the first activation of the gate driver comprises a first set of ON/OFF switching of an output transistor for a first activation time period, and wherein the second activation of the gate driver comprises a second set of ON/OFF switching of the output transistor for a second activation time period.

4. The power supply of claim 1, wherein the modified current comprises an increased current compared to a power supplied without the power factor correction bias circuit.

5. The power supply of claim 1, wherein the power factor correction bias circuit comprises a voltage supply in electrical communication with a voltage divider that is configured to generate the offset voltage.

6. The power supply of claim 1, wherein the first reference voltage and the second reference voltage differ by less than a threshold difference.

7. The power supply of claim 6, wherein the threshold difference is on the order of millivolts.

8. The power supply of claim 1, wherein the transconductance amplifier is configured to generate a pull down current signal in response to determining, based on the voltage sense signal, that the output voltage exceeds an output voltage threshold thereby causing the zero power control signal to deactivate the gate driver.

9. The power supply of claim 1, wherein the transconductance amplifier is configured to generate a pull up current signal in response to determining, based on the voltage sense signal, that the output voltage does not satisfy an output voltage threshold thereby causing the zero power control signal to activate the gate driver.

10. The power supply of claim 1, wherein the power factor correction controller further comprises a multiplier configured to multiply a voltage amplifier output with a scaled full wave rectified AC input voltage to obtain a multiplier output at the current multiplier node.

11. An audio amplifier system comprising:
an audio amplifier; and
a power supply configured to power the audio amplifier, the power supply comprising:
a power factor correction controller comprising a gate driver node, a voltage sense node, a current multiplier node, a transconductance amplifier, and a comparator, wherein the transconductance amplifier compares a voltage sense signal corresponding to an output voltage of the power supply to a first reference voltage, and wherein the comparator compares an input to the comparator corresponding to an output of the transconductance amplifier to a second reference voltage to generate a zero power control signal; and
a power factor correction bias circuit in electrical communication with the current multiplier node, wherein the power factor correction bias circuit applies an offset voltage to the current multiplier node to cause a modified current to be applied across an output inductor of the power supply when the zero power control signal activates a gate driver of the power supply during a no load condition.

12. The audio amplifier system of claim 11, wherein the power factor correction bias circuit increases a time between a first activation of a gate driver and a second activation of the gate driver compared to a power supply without the power factor correction bias circuit, wherein the first activation of the gate driver comprises a first set of ON/OFF switching of an output transistor for a first activation time period, and wherein the second activation of the gate driver comprises a second set of ON/OFF switching of the output transistor for a second activation time period.

13. The audio amplifier system of claim 11, wherein the power factor correction bias circuit comprises a voltage supply in electrical communication with a voltage divider that is configured to generate the offset voltage.

14. The audio amplifier system of claim 11, wherein the transconductance amplifier is configured to generate a pull down current signal in response to determining, based on the voltage sense signal, that the output voltage exceeds an output voltage threshold thereby causing the zero power control signal to deactivate the gate driver.

15. The audio amplifier system of claim 11, wherein the transconductance amplifier is configured to generate a pull up current signal in response to determining, based on the voltage sense signal, that the output voltage does not satisfy an output voltage threshold thereby causing the zero power control signal to activate the gate driver.
